# FASCICULE DE BREVET EUROPEEN

(11) **EP 3 660 930 B1**
(45) Date de publication et mention de la délivrance du brevet: **31.03.2021**
(21) Numéro de dépôt: 19211790.1
(22) Date de dépôt: 27.11.2019
(51) Int. Cl.: H01L 31/18, H01L 31/028, H01L 31/0312, H01L 31/0352, H01L 31/103, H01L 31/105, H01L 27/146

(54) **PROCÉDÉ DE FABRICATION D'UNE MATRICE DE PHOTODIODES À BASE DE GERMANIUM ET À FAIBLE COURANT D'OBSCURITÉ**
HERSTELLUNGSVERFAHREN EINER FOTODIODENMATRIX AUF GERMANIUMBASIS UND MIT SCHWACHEM DUNKELSTROM
METHOD FOR MANUFACTURING A PHOTODIODE ARRAY MADE OF GERMANIUM AND WITH LOW DARK CURRENT

(30) Priorité: 30.11.2018 FR 1872106
(43) Date de publication de la demande: 03.06.2020
(73) Titulaire: Commissariat à l'énergie atomique et aux énergies alternatives, 75015 Paris (FR)
(72) Inventeur: OUVRIER-BUFFET, Jean-Louis, 38054 Grenoble cedex 09 (FR); ALIANE, Abdelkader, 38054 Grenoble cedex 09 (FR); HARTMANN, Jean-Michel, 38054 GRENOBLE Cedex 09 (FR); WIDIEZ, Julie, 38054 GRENOBLE cedex 9 (FR)
(74) Mandataire: INNOV-GROUP

(56) Documents cités:
- CN-A- 107 871 800
- US-A1- 2011 272 561
- US-A1- 2017 012 143

## Description

### DOMAINE TECHNIQUE

Le domaine de l'invention est celui des photodiodes réalisées à base de germanium. L'invention trouve une application notamment dans le domaine de la détection d'un rayonnement lumineux appartenant au proche infrarouge.

### ÉTAT DE LA TECHNIQUE ANTÉRIEURE

Les photodiodes à base de germanium sont adaptées à détecter un rayonnement lumineux dans le proche infrarouge (SWIR, pour *Short Wavelength IR*, en anglais). Leur utilisation est avantageuse notamment lorsqu'il s'agit de détecter la présence d'éléments chimiques dont la signature spectrale est située dans la gamme SWIR. Il peut ainsi s'agir de l'eau, de lipides, d'éléments chimiques présents dans les tissus biologiques, etc... Elles sont également utilisées dans le domaine des télécommunications, ainsi que dans celui dit des datacom.

Les photodiodes à base de germanium présentent habituellement une structure en mesa, dans laquelle les diodes sont réalisées à partir d'un empilement de couches semiconductrices parmi lesquelles une couche inférieure dopée de type p reposant sur un substrat de croissance, une couche intermédiaire intrinsèque, et une couche supérieure dopée de type n. La pixellisation entre les photodiodes est obtenue par gravure localisée, de sorte que la bordure latérale de chaque photodiode peut alors être définie par chacune des couches semiconductrices. La face supérieure de la couche dopée n et la bordure latérale sont alors revêtues par une couche de passivation réalisée en un matériau diélectrique, par exemple un oxyde de silicium. La structure étant de type mesa, la couche diélectrique de passivation s'étend de manière tridimensionnelle de manière à recouvrir la photodiode, et non pas de manière essentiellement planaire.

Il existe un besoin permanent de disposer d'une matrice de photodiodes à faible pas, présentant un facteur de remplissage plus important que dans le cas des photodiodes en mesa, le facteur de remplissage étant défini comme le rapport de la surface de détection sur la surface totale de la photodiode. Il importe alors d'assurer une bonne passivation de la face supérieure et de la bordure latérale des photodiodes, dans la mesure où la composante de surface du courant d'obscurité peut alors devenir prédominante.

Cependant, il apparaît que la présence de la couche diélectrique de passivation peut malgré tout contribuer à générer un courant d'obscurité non négligeable. A ce titre, l'article de Sood et al. intitulé Characterization of SiGe-Detector Arrays for Visible-NIR Imaging Sensor Applications, Proc. of SPIE VOL. 8012, 801240, 2011, décrit un procédé de fabrication d'une photodiode permettant de limiter le courant d'obscurité. Le courant d'obscurité est lié à la présence d'une zone déplétée située dans le matériau semiconducteur de la photodiode, à l'interface avec la couche diélectrique de passivation. Le procédé de fabrication comporte alors une étape de recuit de la photodiode sous N₂H₂, permettant de transformer cette zone déplétée en une zone d'accumulation de trous. Il apparaît que cette étape permet de réduire l'intensité du courant d'obscurité.

Cependant, cette étape de recuit, destinée à modifier la zone déplétée en une zone d'accumulation, peut induire une dégradation des performances de la photodiode, notamment du fait d'une modification non souhaitée des dimensions de la couche dopée n, dans la mesure où le coefficient de diffusion des éléments dopants de type n dans le germanium (par ex. le phosphore) peut être importante. Par ailleurs, la présence et les caractéristiques de la zone déplétée peuvent être liées à la technique utilisée de dépôt de la couche diélectrique de passivation ainsi qu'aux conditions opératoires. Il en résulte que le recuit en question peut alors ne pas permettre d'obtenir de manière reproductible la zone d'accumulation souhaitée et donc la réduction voulue du courant d'obscurité

Le document CN 107 871 800 A divulgue un procédé de fabrication d'un dispositif optoélectronique comportant une photodiode planaire réalisée à base de germanium.

### EXPOSÉ DE L'INVENTION

L'invention a pour objectif de remédier au moins en partie aux inconvénients de l'art antérieur, et plus particulièrement de proposer un procédé de fabrication d'une matrice de photodiodes planaires à base de germanium, présentant ainsi un facteur de remplissage élevé, et permettant d'obtenir un faible courant d'obscurité tout en préservant les propriétés de la ou des photodiodes, et en particulier les dimensions de la ou des régions dopées n.

Pour cela, l'objet de l'invention est un procédé de fabrication d'un dispositif optoélectronique comportant une matrice de photodiodes planaires réalisées à base de germanium, comportant les étapes suivantes :
i) réalisation d'un empilement de couches semiconductrices, réalisées à base de germanium, présentant une première face et une deuxième face opposées l'une à l'autre et parallèles à un plan principal des photodiodes, et comportant :
   ∘ une première couche, dopée de type p, et définissant la première face,
   ∘ une deuxième couche, recouvrant la première couche, et définissant la deuxième face,
ii) réalisation de tranchées, s'étendant au travers dudit empilement à partir de la deuxième face en direction de la première face, délimitant pour chaque photodiode une portion semiconductrice dudit empilement ;
iii) dépôt d'une couche semiconductrice intrinsèque de passivation, réalisée à base de silicium, recouvrant la deuxième face et remplissant les tranchées ;
iv) recuit, assurant, pour chaque photodiode, une interdiffusion du silicium de la couche semiconductrice de passivation et du germanium de la portion semiconductrice, formant ainsi une zone dite périphérique de la portion semiconductrice, réalisée à base de silicium germanium, et située au contact de la couche semiconductrice de passivation.

Certains aspects préférés mais non limitatifs de ce procédé de fabrication sont les suivants.

Le procédé peut comporter, à la suite de l'étape de recuit d'interdiffusion, une étape de réalisation, pour chaque photodiode, d'une région dite supérieure dopée n de la portion semiconductrice, affleurant la deuxième face et située à distance d'une bordure latérale de la portion semiconductrice reliant les première et deuxième faces l'une à l'autre, par les sous-étapes suivantes :
- implantation ionique localisée d'éléments dopants de type n dans une portion dite centrale de la couche semiconductrice de passivation,
- recuit, assurant une diffusion des éléments dopants de type n depuis la portion centrale vers la portion semiconductrice, formant ainsi la région supérieure dopée n.

Le procédé peut comporter une étape de dopage de parties dites latérales de la couche semiconductrice de passivation, situées dans les tranchées, par implantation ionique localisée d'éléments dopants de type p, formant ainsi pour chaque photodiode une partie latérale dopée p, suivie d'une étape de recuit assurant la diffusion des éléments dopants de type p depuis les parties latérales vers les portions semiconductrices, formant ainsi, dans chaque portion semiconductrice, une région dite latérale dopée p affleurant une bordure latérale de la portion semiconductrice.

L'étape de recuit de diffusion des éléments dopants du type p peut être effectuée avant ou lors de l'étape de recuit de diffusion des éléments dopants du type n.

Le procédé peut comporter une étape de réalisation d'une couche d'interconnexion électrique, comportant :
- un dépôt d'une couche isolante supérieure réalisée en un matériau diélectrique, recouvrant la couche semiconductrice de passivation, puis
- une formation, au travers de la couche isolante supérieure, de portions conductrices, venant au contact, pour chaque photodiode, d'une partie dite latérale dopée p de la couche semiconductrice de passivation située dans une tranchée d'une part, et d'une portion dite centrale dopée n de la couche semiconductrice de passivation située sur la deuxième face et au contact d'une région dite supérieure dopée n de la portion semiconductrice.

L'invention porte également sur un dispositif optoélectronique comportant une matrice de photodiodes planaires réalisées à base de germanium, présentant une première face et une deuxième face opposées l'une à l'autre et parallèles à un plan principal des photodiodes, chaque photodiode comportant :
∘ une portion semiconductrice, comportant :
   - une première région dite inférieure dopée de type p et affleurant la première face,
   - une deuxième région dite supérieure dopée de type n et affleurant la deuxième face,
   - une région intermédiaire située entre les première et deuxième régions et entourant la deuxième région dans le plan principal,
∘ une tranchée, s'étendant à partir de la deuxième face en direction de la première face, et définissant une bordure latérale de la portion semiconductrice reliant les première et deuxième faces ;
∘ une couche semiconductrice de passivation, réalisée à base de silicium, recouvrant la deuxième face et remplissant la tranchée ;
∘ une zone dite périphérique réalisée à base de silicium germanium, située dans la portion semiconductrice au contact de la couche semiconductrice de passivation au niveau de la deuxième face et au niveau de la bordure latérale.

La couche semiconductrice de passivation peut comporter une partie dite supérieure s'étendant au contact de la deuxième face, et une partie dite latérale remplissant les tranchées et s'étendant au contact de la bordure latérale, la partie supérieure comportant une portion dite centrale dopée de type n et située au contact de la deuxième région dopée n, et une portion dite périphérique, entourant la portion centrale dans le plan principal.

La partie latérale peut être dopée de type p, et être au contact de la première région dopée p.

Chaque portion semiconductrice peut comporter une région dite latérale dopée de type p et située au contact de la partie latérale dopée p.

Le dispositif optoélectronique peut comporter une puce de commande adaptée à polariser les photodiodes, assemblée et électriquement connectée à la matrice de photodiodes au niveau de la deuxième face.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1 est une vue schématique et partielle, en coupe, d'une photodiode d'une matrice de photodiodes planaire selon un mode de réalisation ;
les figures 2A à 2L illustrent, de manière schématique et partielle, différentes étapes d'un procédé de fabrication d'une matrice de photodiodes selon le mode de réalisation illustré sur la fig.1.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près.

L'invention porte d'une manière générale sur un procédé de fabrication d'un dispositif optoélectronique comportant une matrice de photodiodes réalisées à base de germanium. Chaque photodiode est ainsi adaptée à détecter un rayonnement lumineux dans le proche infrarouge (SWIR, pour *Short Wavelength IR,* en anglais) correspondant à la gamme spectrale allant de 0,8µm à 1,7µm environ, voire à 2,5µm environ.

Les photodiodes sont dites planaires dans la mesure où elles s'étendent suivant un même plan principal, entre des première et deuxième faces parallèles et opposées l'une à l'autre. Elles comportent chacune une portion semiconductrice dite de détection, au sein de laquelle est présente une jonction PN ou PIN, présentant une épaisseur sensiblement constante entre les première et deuxième faces. Chaque photodiode comporte une première région dite inférieure dopée de type p et affleurant la première face de manière continue, une deuxième région dite supérieure dopée de type n et affleurant localement la deuxième face et formant un caisson dopé, et une région intermédiaire située entre les deux régions dopées et entourant la deuxième région dopée dans le plan principal. Cette région intermédiaire peut être dopée de type p, pour former une jonction PN, ou être intrinsèque, c'est-à-dire non intentionnellement dopée, pour former une jonction PIN. Les photodiodes planaires ne présentent alors pas une structure en mesa, et sont isolées optiquement les unes des autres par des tranchées remplies ici par une partie d'une couche semiconductrice de passivation réalisée à base de silicium. Elles présentent ainsi un facteur de remplissage particulièrement élevé. Par ailleurs, les photodiodes sont dites passivées dans la mesure où la deuxième face ainsi que la bordure latérale définie par les tranchées sont revêtues par la couche semiconductrice de passivation réalisée à base de silicium. Comme décrit en détail plus loin, la couche semiconductrice de passivation est notamment destinée à réduire la composante de surface du courant d'obscurité de chaque photodiode. Elle est avantageusement utilisée pour appliquer un potentiel électrique à la première région dopée p+ à partir de la deuxième face.

D'une manière générale, le courant d'obscurité d'une photodiode est le courant électrique présent au sein de la photodiode en fonctionnement, lorsqu'elle n'est pas soumise à un rayonnement lumineux. Il peut être formé de courants générés thermiquement à l'intérieur du volume de la portion semiconductrice de détection (courants de diffusion, courants de déplétion, courants tunnel...) et de courants de surface.

Les courants de surface peuvent être liés à la présence de charges électriques dans la couche de passivation lorsqu'elle est réalisée en un matériau diélectrique, par exemple en un oxyde de silicium. En effet, ces charges électriques peuvent induire une modification de la courbure des bandes d'énergie à proximité de la surface, conduisant à la formation d'une zone déplétée ou d'une zone d'inversion. La zone déplétée, lorsqu'elle est située dans la zone de charge d'espace de la photodiode, peut donner lieu à des courants parasites de type génération-recombinaison. Par ailleurs, la zone d'inversion, alors électriquement conductrice, peut permettre le déplacement de charges électriques entre des régions polarisées dopées n et p, et situées à l'interface avec la couche diélectrique de passivation.

Les courants de surface peuvent également être liés à la présence de défauts du matériau semiconducteur de la photodiode, ces défauts étant notamment situés à proximité des surfaces de la portion semiconductrice de détection, en particulier au niveau de la bordure latérale et de la deuxième face. Ces défauts peuvent provenir de la gravure localisée effectuée pour former les tranchées, ainsi que de l'incorporation non souhaitée de contaminants lors d'étapes technologiques du procédé de fabrication. Ces défauts peuvent être à l'origine de la création de porteurs minoritaires en l'absence d'un rayonnement lumineux. Ces porteurs minoritaires non photogénérés peuvent alors diffuser jusqu'à la zone de charge d'espace de la photodiode et créer un courant électrique, ici un courant d'obscurité.

Le procédé de fabrication selon un mode de réalisation permet ainsi d'obtenir une matrice de photodiodes planaires réalisées à base de germanium, passivées par une couche semiconductrice de passivation réalisée à base de silicium, et recouvrant la deuxième face ainsi que la bordure latérale dans les tranchées. A l'interface avec la couche semiconductrice de passivation, la portion semiconductrice de détection de chaque photodiode comporte une zone dite périphérique réalisée à base de silicium germanium. Comme détaillé plus loin, une telle zone périphérique présente une concentration en silicium supérieure à celle que peut éventuellement présenter la portion semiconductrice de détection, de sorte qu'elle présente une énergie de bandes interdite (*gap,* en anglais) supérieure à celle de la portion semiconductrice de détection. Cette « ouverture de gap » périphérique est alors située là où les défauts de surface et contaminants potentiels sont présents, ce qui permet de limiter les courants parasites de surface du courant d'obscurité.

Ainsi, le procédé de fabrication permet d'obtenir une matrice de photodiodes planaires à base de germanium à facteur de remplissage élevé et à courant d'obscurité réduit. Comme il est détaillé par la suite, la zone périphérique à ouverture de gap est obtenue sans provoquer une modification sensible des caractéristiques de la portion semiconductrice de détection, et plus précisément sans induire une modification des dimensions de la première région dopée p et avantageusement de la deuxième région dopée n.

Pour des raisons de clarté, on illustrera tout d'abord une photodiode d'une matrice de photodiodes à base de germanium, planaires et passivées, obtenue par le procédé de fabrication selon un mode de réalisation.

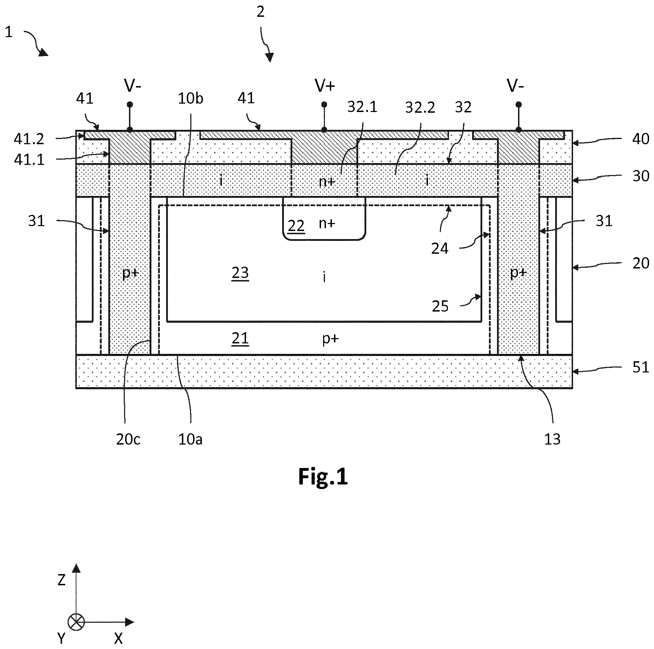

La figure 1 est une vue partielle et schématique, en coupe transversale, d'une telle photodiode 2 planaire passivée appartenant à une matrice de photodiodes 2 réalisées à base de germanium. Elles sont ici polarisées, par exemple en inverse, à partir de la deuxième face 10b et sont passivées et optiquement isolées les unes des autres par une couche semiconductrice de passivation 30 s'étendant sur la deuxième face 10b et remplissant des tranchées 13 de pixellisation.

On définit ici et pour la suite de la description un repère direct tridimensionnel (X,Y,Z), où les axes X et Y forment un plan parallèle au plan principal des photodiodes 2, et où l'axe Z est orienté suivant l'épaisseur de la portion semiconductrice de détection 20 de la photodiode, à partir de la première face 10a en direction de la deuxième face 10b. Par ailleurs, les termes « inférieur » et « supérieur » se réfèrent à un positionnement croissant suivant la direction +Z.

Chaque photodiode 2 comporte une portion semiconductrice de détection 20 s'étendant suivant l'axe Z entre une première et une deuxième faces 10a, 10b parallèles et opposées l'une à l'autre, et est délimitée dans le plan XY par une bordure latérale 2oc qui relie les deux faces entre elles. Les première et deuxième faces 10a, 10b sont communes à chaque photodiode 2 de la matrice. Elles peuvent être sensiblement planes, de sorte que la portion semiconductrice de détection 20 présente une épaisseur suivant l'axe Z sensiblement constante, par exemple comprise entre quelques centaines de nanomètres et quelques microns, par exemple comprise entre 1µm et 10µm environ. L'épaisseur est choisie de manière à obtenir une bonne absorption dans la gamme de longueurs d'onde du rayonnement lumineux à détecter. La portion semiconductrice de détection 20 présente une dimension transversale dans le plan XY pouvant être comprise entre quelques centaines de nanomètres et quelques dizaines de microns, par exemple comprise entre 1µm et 100µm, de préférence entre 1µm et 20µm environ.

La portion semiconductrice de détection 20 est réalisée en un matériau semiconducteur cristallin à base de germanium, de préférence monocristallin. Par à base d'un élément chimique d'intérêt, on entend que le matériau semiconducteur cristallin correspond à l'élément chimique d'intérêt ou est un alliage formé d'au moins l'élément chimique d'intérêt. Les photodiodes 2 peuvent donc être réalisées en germanium Ge, en silicium germanium SiGe, le germanium étain GeSn, ou le silicium germanium étain SiGeSn. Dans cet exemple, la portion semiconductrice de détection 20 est issue d'au moins une couche réalisée en germanium. Elle peut ainsi être une couche ou un substrat réalisé en le même matériau semiconducteur à base de germanium et présenter des régions de différents types de conductivité (homojonction) pour former une jonction PN ou PIN. Elle peut en variante être un empilement de sous-couches de différents matériaux semiconducteurs à base de germanium (hétérojonction), lesquels sont alors formés à base de germanium. Le matériau semiconducteur de la portion semiconductrice de détection 20 présente, hors d'une zone périphérique 24 décrite plus loin, une première concentration de silicium qui peut être nulle ou non nulle.

La portion semiconductrice de détection 20 est ainsi formée d'une première région 21 dopée de type p, qui affleure la première face 10a et s'étend dans le plan XY à partir de la bordure latérale 20C, d'une deuxième région 22 dopée de type n, qui affleure localement la deuxième face 10b et forme un caisson dopé n situé à distance de la bordure latérale 20c, et d'une région intermédiaire 23 intrinsèque (dans le cas d'une jonction PIN), ou dopée p (dans le cas d'une jonction PN), située entre et au contact des deux régions dopées 21, 22, et entoure la deuxième région 22 dopée n dans le plan principal. Par affleurer, on entend « arriver au niveau de », ou « s'étend à partir de ». Dans cet exemple, la jonction semiconductrice est de type PIN, la première région 21 étant dopée de type p+, la deuxième région 22 dopée de type n+ et la région intermédiaire 23 est intrinsèque (non intentionnellement dopée).

La première région 21 dopée ici p+ s'étend dans le plan XY en affleurant la première face 10a, ici à partir de la bordure latérale 20c. Elle s'étend suivant l'axe Z à partir de la première face 10a. Elle peut présenter une épaisseur sensiblement homogène suivant l'axe Z et ainsi affleurer uniquement une zone inférieure de la bordure latérale 20c. En variante, comme illustré sur la fig.1, la première région 21 dopée p+ peut avantageusement présenter une région latérale 25 dopée p+ qui affleure continûment la bordure latérale 20C suivant l'axe Z et s'étend sur toute la périphérie de la portion semiconductrice de détection 20. La première région 21 dopée p+ peut présenter un dopage pouvant être compris entre 10¹⁸ et 10²⁰ at/cm³ environ.

La deuxième région 22 dopée n+ s'étend ici à partir de la deuxième face 10b et est entourée par la région intermédiaire 23 dans le plan principal. Elle est distante de la bordure latérale 20c de la portion semiconductrice de détection 20 dans le plan XY. Elle forme ainsi un caisson dopé n qui affleure la deuxième face 10b et est espacée d'une distance non nulle vis-à-vis de la bordure latérale 20c ainsi que de la première face 10a. La deuxième région 22 dopée n participe ainsi à délimiter la deuxième face 10b. Elle peut présenter un dopage pouvant être compris entre 10¹⁹ et 10²¹ at/cm3 environ.

La région intermédiaire 23 est située entre les deux régions dopées n+ et p+. Elle entoure donc la deuxième région 22 dopée n+ dans le plan XY et affleure localement la deuxième face 10b. Elle est ici intrinsèque de manière à former une jonction PIN mais peut être dopée p pour former une jonction PN.

Le dispositif optoélectronique 1 peut comporter une couche isolante inférieure 51, réalisée en un matériau diélectrique, recouvrant la première face 10a de la portion semiconductrice de détection 20, ainsi que, comme décrit plus loin, la face inférieure de tranchées 13 remplies d'un matériau semiconducteur de passivation à base de silicium. La tranchée 13 peut alors participer à polariser électriquement la photodiode, ici à partir de la deuxième face, et à pixelliser la matrice de photodiodes 2 (isolation optique). La couche isolante inférieure 51 peut en outre être adaptée à former une fonction d'antireflet vis-à-vis du rayonnement lumineux incident. Elle forme en effet la face de réception du rayonnement lumineux destiné à être détecté.

La portion semiconductrice de détection 20 de chaque photodiode 2 est délimitée latéralement, dans le plan XY, par une tranchée 13, de préférence continue, qui s'étend ici sur toute l'épaisseur de la portion semiconductrice de détection 20 pour déboucher sur la couche isolante inférieure 51. En variante, la tranchée 13 peut ne pas déboucher sur la couche isolante inférieure 51 et peut se terminer dans la première région 21 dopée p+. Les tranchées 13 peuvent présenter des dimensions transversales, dans le plan XY, de l'ordre de 0.5µm à 2.0µm.

Une couche semiconductrice de passivation 30 recouvre continûment la deuxième face 10b et remplit entièrement les tranchées 13. Elle est ainsi au contact de la première région 21 dopée p+ au niveau de la bordure latérale 20c, de la région intermédiaire 23 au niveau de la bordure latérale 20c et de la deuxième face 10b, et de la deuxième région 22 dopée n+ au niveau de la deuxième face 10b. Elle est réalisée en un matériau semiconducteur à base de silicium. Elle est ainsi formée d'une partie supérieure 32 au contact de la deuxième face 10b et d'une partie latérale 31 remplissant la tranchée 13. Les parties supérieure 32 et latérale 31 forment deux zones continues, jointes, d'une même couche semiconductrice de passivation 30. Celle-ci est réalisée à base de silicium, et peut être, par exemple, du silicium amorphe, du silicium polycristallin, du silicium germanium. La couche semiconductrice de passivation 30 présente une concentration en silicium supérieure à celle du matériau semiconducteur à base de germanium de la portion semiconductrice de détection 20. La partie supérieure 32 peut présenter une épaisseur, suivant l'axe Z, par exemple comprise entre 100nm et 1µm.

Comme mentionné précédemment, des défauts du matériau semiconducteur à base de germanium peuvent être présents à proximité de la bordure latérale 20C et la deuxième face 10b de la portion semiconductrice de détection 20. Ces défauts peuvent provenir, pour ce qui concerne la bordure latérale 20c, de la gravure localisée effectuée pour obtenir les tranchées 13. En ce qui concerne la deuxième face 10b, ils peuvent provenir d'éléments contaminants incorporés de manière non voulue lors d'étapes technologiques mises en œuvre lors du procédé de fabrication. Ces défauts et ces contaminants peuvent introduire un niveau d'énergie intermédiaire dans la bande d'énergie interdite du matériau semiconducteur à base de germanium, qui peut alors permettre le passage spontané d'un porteur de charge d'une bande d'énergie à une autre, créant ainsi une paire électron-trou et donc un porteur minoritaire. Celui-ci, lorsqu'il diffuse jusqu'à la zone de charge d'espace, peut alors contribuer au courant d'obscurité.

Par ailleurs, une couche de passivation réalisée en un matériau diélectrique peut malgré tout participer à générer une contribution surfacique du courant d'obscurité. En effet, comme l'indique l'article de Sood et al. 2011 mentionné précédemment, une couche diélectrique de passivation peut induire la formation d'une zone déplétée dans la région intermédiaire 23 à partir de la deuxième face 10b. Lorsque cette zone déplétée est située dans la zone de charge d'espace de la photodiode, elle peut alors être le lieu d'un courant parasite de génération-recombinaison. Par ailleurs, la couche diélectrique de passivation peut former une zone d'inversion, alors électriquement conductrice, qui peut donc connecter la deuxième région 22 dopée n+ à la partie latérale 31 ici dopée p+.

Aussi, la couche semiconductrice de passivation 30, par un recuit d'interdiffusion (*intermixing,* en anglais) mis en œuvre lors du procédé de fabrication, conduit à la formation d'une zone périphérique 24 à base de silicium germanium dans chaque portion semiconductrice de détection 20, au niveau de la deuxième face 10b et de la bordure latérale 20c. Dans cette zone périphérique 24 (délimitée par un trait en pointillé sur les figures), la concentration en silicium est supérieure à celle que peut avoir le matériau semiconducteur de la portion semiconductrice de détection 20. A titre d'exemple, la portion semiconductrice de détection 20 est ici réalisée en germanium, la couche semiconductrice de passivation 30 est réalisée en silicium, et la zone périphérique 24 est en silicium germanium. Or, du fait de la concentration plus élevée en silicium dans la zone périphérique 24 que dans le reste de la portion semiconductrice de détection 20, le gap y est plus élevé. Aussi, ce gap élevé est localisé dans les zones où sont situés les défauts cristallins et les contaminants potentiels. La probabilité qu'un porteur de charge puisse franchir le gap de manière spontanée est alors réduite. La couche semiconductrice de passivation 30 permet donc de réduire les courants parasites de surface et en conséquence de diminuer le courant d'obscurité. Par ailleurs, cette ouverture de gap se traduit également par la formation d'une barrière de potentiel vis-à-vis des porteurs minoritaires photogénérés qui diffuseraient en direction des défauts cristallins et des contaminants situés à proximité de la bordure latérale 20c et de la deuxième face 10b. Ainsi, on évite que des porteurs photogénérés ne se recombinent sans être détectés et ne participent au signal électrique utile de détection. Les performances des photodiodes 2 sont alors améliorées.

De plus, comme décrit plus loin, le recuit d'interdiffusion ne conduit pas à une modification sensible des dimensions de la première région 21 dopée p+, dans la mesure où les éléments dopants du type p dans le germanium (bore, gallium...) présentent un coefficient de diffusion réduit. Par contre, les éléments dopants de type n dans le germanium (phosphore, arsenic, antimoine...) présentent un coefficient de diffusion élevé, le recuit d'interdiffusion étant alors avantageusement effectué avant l'étape de réalisation des deuxièmes régions 22 dopées n+.

Par ailleurs, la portion semiconductrice de détection 20 comporte avantageusement une région latérale 25 dopée de type p+, située au niveau de la bordure latérale 20C. Cette région latérale 25 présente un niveau de dopage supérieur à celui de la région intermédiaire 23 lorsqu'elle est dopée. La région latérale 25 dopée p+ affleure la bordure latérale 20C et est au contact de la partie latérale 31 dopée p+. Comme décrit plus loin, elle est obtenue lors du recuit d'interdiffusion, ou lors d'un recuit spécifique de diffusion des éléments dopants. Ainsi, la polarisation de la première région 21 dopée p+ est améliorée dans la mesure où la surface de contact avec la partie latérale 31 dopée p+ est augmentée. De plus, cette région latérale 25 dopée p+ permet d'éviter que la zone de charge d'espace de la photodiode 2 ne s'étende jusqu'à la bordure latérale 20c. Ainsi, on limite la contribution de cette zone (potentiellement non exempte de défauts liés à la réalisation des tranchées 13) au courant d'obscurité. On améliore ainsi les performances de la photodiode 2.

Dans cet exemple, le dispositif optoélectronique 1 comporte en outre un circuit électrique permettant de polariser chaque photodiode 2, par exemple en inverse. Aussi, la couche semiconductrice de passivation 30 comporte des parties latérales 31 dopées de type p+ affleurant la face supérieure sensiblement plane de la couche semiconductrice de passivation 30, ainsi qu'une portion centrale 32.1 dopée n+ de la partie supérieure 32, affleurant la face supérieure et située au contact de la deuxième région 22 dopée n+. Le circuit électrique est ici adapté à polariser les photodiodes 2 à partir de la deuxième face 10b. Le circuit électrique comporte ici des métallisations de contact 41 s'étendant au travers d'ouvertures traversantes d'une couche isolante supérieure 40 qui revêt la couche semiconductrice de passivation 30, et venant au contact des parties latérales 31 dopées p+ d'une part, et de la portion centrale 32.1 dopée n+ d'autre part. Les métallisations de contact 41 présentent ici une partie inférieure 41.1 venant au contact des zones dopées 31, 32.1 de la couche semiconductrice de passivation 30, et une partie supérieure 41.2 affleurant la face supérieure et présentant des dimensions dans le plan XY plus importantes que celles de la partie inférieure 41.1. Les métallisations de contact 41 assurent ici également un rôle de réflecteur vis-à-vis du rayonnement lumineux incident provenant de la première face 10a (celle-ci jouant le rôle de face de réception optique). On améliore ainsi la proportion absorbée du rayonnement lumineux incident dans la portion semiconductrice de détection 20.

Notons que la couche semiconductrice de passivation 30 a été obtenue par dépôt d'un matériau semiconducteur intrinsèque à base de silicium. Aussi, la partie latérale 31 dopée p+ et la portion centrale 32.1 dopée n+ sont électriquement isolées l'une de l'autre par une portion périphérique 32.2 réalisée à base de silicium intrinsèque, et présentant donc une résistivité électrique élevée, proche de celle des matériaux diélectriques, par exemple supérieure à 10⁹Ω.cm. Aussi, tout risque de court-circuit entre la partie latérale 31 dopée p+ et la portion centrale 32.1 dopée n+, lorsqu'elles sont polarisées, est ainsi écarté.

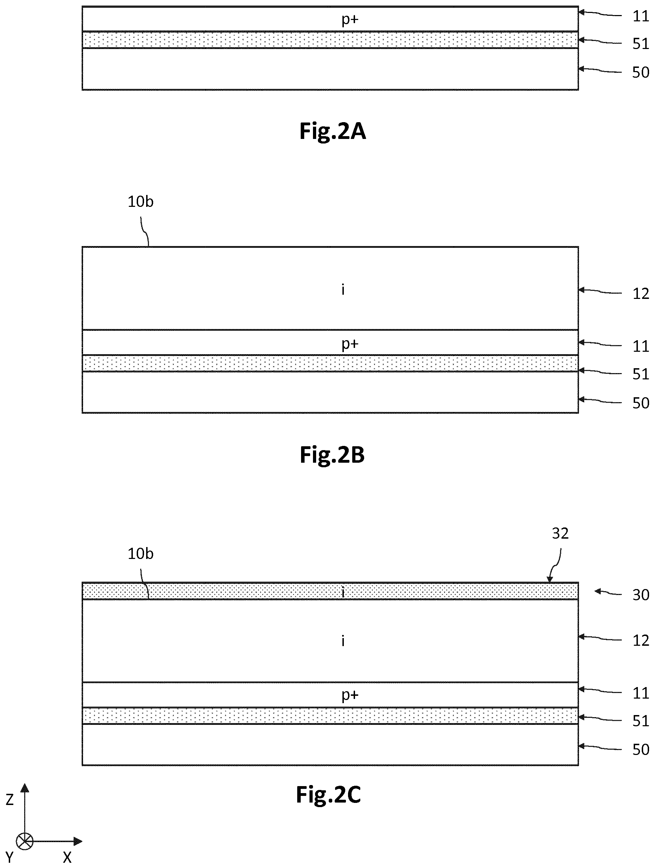

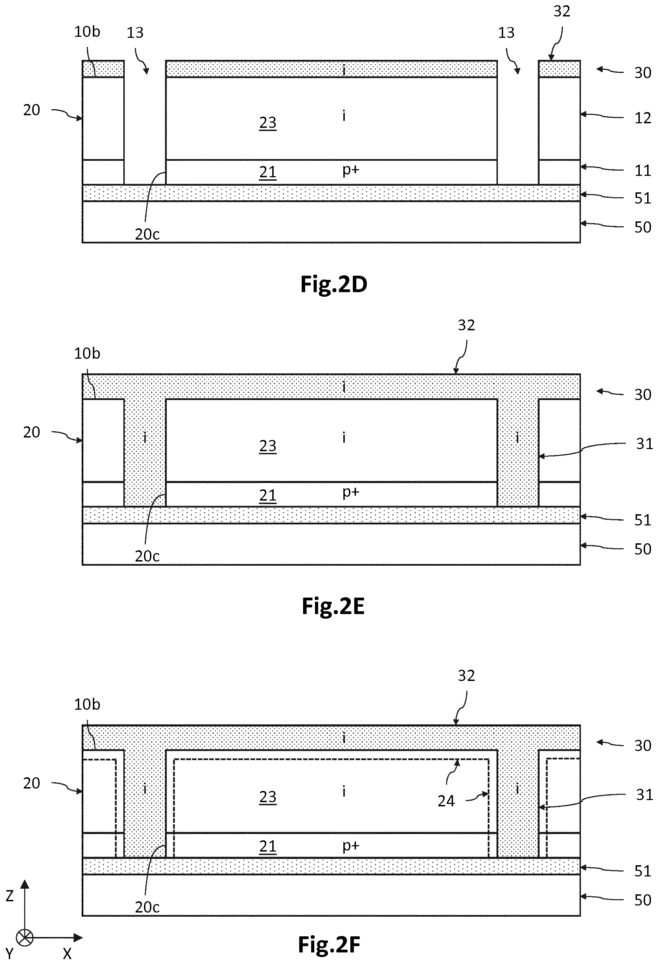

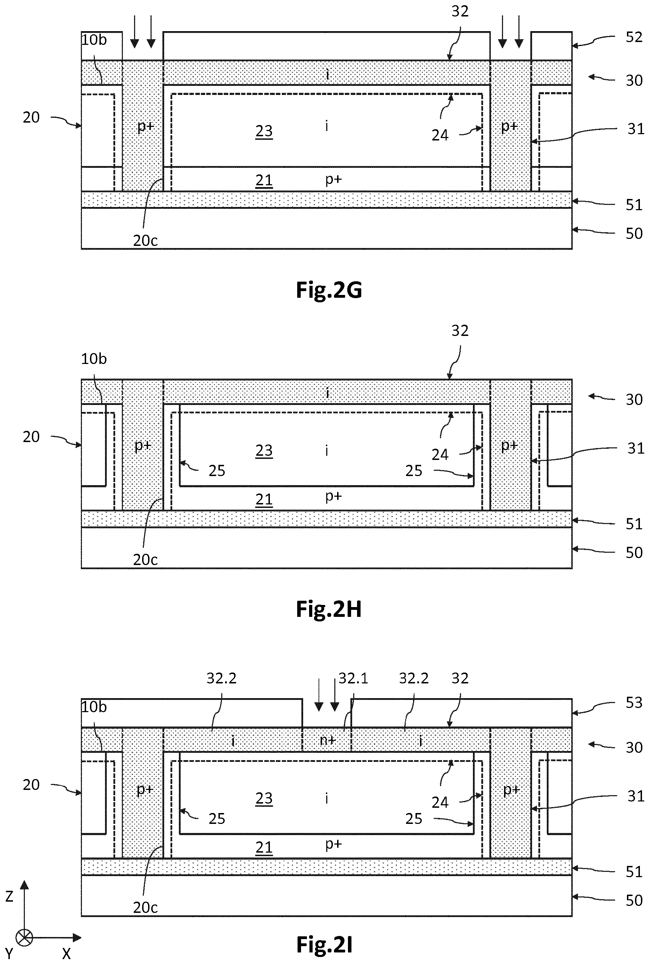

Un exemple de procédé de fabrication d'une matrice de photodiodes 2 planaires selon le mode de réalisation illustré sur la fig.1 est maintenant décrit en référence aux figures 2A à 2L. Dans cet exemple, les photodiodes 2 sont réalisées en germanium et comportent une jonction PIN, et sont adaptées à détecter un rayonnement infrarouge dans la gamme SWIR. Les photodiodes 2 sont planaires, et sont passivées par une couche semiconductrice de passivation 30 qui s'étend à la fois au contact de la deuxième face 10b et au contact de la bordure latérale 20C dans les tranchées 13. Cette couche semiconductrice de passivation 30 permet avantageusement d'assurer la polarisation, par exemple en inverse, de chaque photodiode 2 à partir de la deuxième face 10b.

Lors d'une première étape (fig.2A), on réalise une première couche semiconductrice 11 de germanium monocristallin. La première couche semiconductrice 11 est solidarisée à une couche support 50, ici en silicium, par l'intermédiaire d'une couche isolante inférieure 51, ici en un oxyde de silicium. Cet empilement prend la forme d'un substrat GeOI (pour *Germanium On Insulator,* en anglais). Cet empilement est de préférence réalisé au moyen du procédé décrit dans la publication de Reboud et al. intitulée Structural and optical properties of 200mm germanium-on-insulator (GeOI) substrates for silicon photonics applications, Proc. SPIE 9367, Silicon Photonics X, 936714 (February 27, 2015). Un tel procédé présente l'avantage de réaliser une couche semiconductrice 11 de germanium présentant une absence ou un faible taux de défauts structuraux tels que les dislocations. Le germanium peut être non intentionnellement dopé ou être dopé, par exemple de type p. La couche semiconductrice 11 peut présenter une épaisseur comprise entre 20nm et 500nm environ, par exemple égale à 300nm environ, et peut être recouverte d'une couche de protection (non représentée) en un oxyde de silicium. La couche isolante inférieure 51 (BOX, pour *Buried Oxide,* en anglais) peut présenter une épaisseur comprise entre 50nm et 1µm et assure avantageusement une fonction d'antireflet.

On réalise ensuite un dopage de type p de la première couche 11 en germanium, par implantation ionique d'un dopant tel que le bore ou le gallium, lorsque le germanium est intrinsèque. La couche de protection, le cas échéant, a été préalablement retirée par un nettoyage de surface, et la première couche 11 de germanium peut être revêtue d'une couche d'oxyde de préimplantation (non représentée) d'une épaisseur de quelques dizaines de nanomètres, par exemple égale à 20nm. La couche 11 de germanium présente alors un niveau de dopage compris entre 10¹⁸ et 10²⁰ at/cm³ environ. Un recuit de diffusion du dopant peut ensuite être effectué sous azote, pendant quelques minutes à quelques heures, par exemple 1h, à une température pouvant être comprise entre 600°C et 800°C, par exemple égale à 800°C. En variante, la première couche 11 peut être dopée p+ par du bore ou du gallium lors de la formation du GeOI, auquel cas cette étape de dopage n'est pas effectuée.

Lors d'une étape suivante (fig.2B), on réalise une deuxième couche semiconductrice 12 de germanium par épitaxie à partir de la première couche 11. Les deux couches 11, 12 sont destinées à former les portions semiconductrices de détection 10 coplanaires en germanium de la matrice de photodiodes 2. La deuxième couche 12 est formée par épitaxie, par exemple par dépôt chimique en phase vapeur (CVD, pour *Chemical Vapor Deposition,* en anglais) ou par toute autre technique d'épitaxie. Cette couche peut subir différents recuits pour diminuer le taux de dislocations. La couche d'oxyde de préimplémentation, le cas échéant, a été préalablement retirée par un nettoyage de surface. La deuxième couche 12 de germanium est ici intrinsèque, c'est-à-dire non intentionnellement dopée. Elle est destinée à former la zone d'absorption lumineuse des photodiodes 2. Son épaisseur dépend de la gamme de longueurs d'onde du rayonnement lumineux à détecter dans le cas d'une photodiode 2. Dans le cadre de photodiodes 2 SWIR, la deuxième couche 12 de germanium intrinsèque présente une épaisseur par exemple comprise entre 0,5µm et 3µm, de préférence égale à 1,5µm.

Lors d'une étape suivante (fig.2C), on dépose une partie dite supérieure 32 de la couche semiconductrice de passivation 30 de manière à recouvrir continûment la face supérieure 10b de la deuxième couche 12, c'est-à-dire de manière à recouvrir ce que seront les différentes portions semiconductrices de détection des photodiodes 2. On réduit ainsi les risques de contamination ou d'oxydation de la surface du germanium. La couche semiconductrice de passivation 30 est réalisée à base d'un matériau semiconducteur intrinsèque, et plus précisément à base de silicium, par exemple du silicium amorphe, du silicium polycristallin, ou du silicium germanium. Un nettoyage de la face supérieure 10b de la deuxième couche 12 peut avoir été effectué. La partie supérieure 32 de la couche semiconductrice de passivation 30 peut présenter une épaisseur comprise entre 3nm et 500nm. En variante, il est possible de réaliser les tranchées 13 avant le dépôt de la couche semiconductrice de passivation 30.

Lors d'une étape suivante (fig.2D), on réalise ensuite, par photolithographie et gravure, les tranchées 13 destinées à pixelliser les photodiodes 2 et à participer ici à les polariser électriquement, par exemple en inverse. On réalise ainsi une gravure localisée de la partie supérieure 32 de la couche semiconductrice de passivation 30, de la deuxième couche 12 de germanium intrinsèque, et de la première couche 11 de germanium dopé p+, jusqu'à déboucher ici sur la couche isolante inférieure 51. Chaque tranchée 13 s'étend ainsi de préférence continûment autour d'une photodiode 2. On obtient ainsi une pluralité de portions semiconductrices de détection 20 séparées les unes des autres par une tranchée 13 continue. Chaque portion semiconductrice de détection 20 est ici formée d'une première région 21 dopée p+ et d'une région intermédiaire 23 ici intrinsèque. Les tranchées 13 sont obtenues de préférence par une technique de gravure anisotrope, de manière à obtenir une bordure latérale 20C sensiblement verticale suivant l'axe Z. Les tranchées 13 présentent une dimension transversale (largeur) dans le plan XY pouvant être comprise entre 300nm et 2µm, par exemple égale à 1µm. Les portions semiconductrices de détection 20 peuvent ainsi présenter une forme dans le plan XY par exemple circulaire, ovale, polygonale, par exemple carrée, ou toute autre forme.

Lors d'une étape suivante (fig.2E), on réalise ensuite la partie latérale 31 de la couche semiconductrice de passivation 30. Pour cela, on dépose un matériau semiconducteur intrinsèque à base de silicium de manière à remplir entièrement les tranchées 13. Le matériau semiconducteur est de préférence identique à celui de la partie supérieure 32 de la couche semiconductrice de passivation 30, à savoir du silicium amorphe, du silicium polycristallin, ou de silicium germanium. Ainsi, on obtient une couche semiconductrice de passivation 30 réalisée à base de silicium intrinsèque, dont la partie supérieure 32 s'étend au contact de la deuxième face 10b et la partie latérale 31 remplit la tranchée 13 et s'étend au contact de la bordure latérale 20c. Les parties latérale 31 et supérieure 32 sont deux parties d'une même couche semiconductrice continue. Une étape de polissage mécanochimique (CMP) peut ensuite être effectuée, pour planariser la face supérieure de la couche semiconductrice de passivation 30.

En variante, les parties latérale 31 et supérieure 32 de la couche semiconductrice de passivation 30 peuvent être obtenues de manière simultanée, par dépôt d'un matériau semiconducteur intrinsèque à base de silicium de manière à s'étendre au contact de la deuxième face 10b et à remplir la tranchée 13.

Lors d'une étape suivante (2F), on effectue ensuite un recuit assurant l'interdiffusion entre le silicium de la couche semiconductrice de passivation 30 et le germanium de la portion semiconductrice de détection 20. On obtient ainsi une zone périphérique 24 réalisée à base de silicium germanium, située dans la portion semiconductrice de détection 20 à l'interface avec la couche semiconductrice de passivation 30. Elle affleure donc la deuxième face 10b et la bordure latérale 20c de manière continue. Cette zone périphérique 24 comporte alors une concentration en silicium supérieure à la concentration en silicium que peut présenter la portion semiconductrice de détection 20 en dehors de cette zone. Le recuit d'interdiffusion peut être effectué à une température par exemple de l'ordre de 700°C à 850°C pendant une durée de l'ordre de 30 minutes à 10 heures.

Dans la mesure où le gap d'un matériau semiconducteur à base de germanium ou de silicium germanium augmente avec la concentration en silicium, la zone périphérique 24 présente un gap supérieur à celui de la portion semiconductrice de détection 20 en-dehors de cette zone 24. Cette zone périphérique 24 à « ouverture de gap » permet ainsi de passiver efficacement la portion semiconductrice de détection 20 et de réduire la composante surfacique du courant d'obscurité associée à la présence de défauts cristallins et/ou de contaminants non souhaités. Elle forme également une barrière de potentiel permettant de réduire le risque qu'un porteur minoritaire photogénéré ne se recombine dans cette zone périphérique 24 sans être détecté par la photodiode 2.

Lors d'une étape suivante (fig.2G), on effectue une implantation ionique d'éléments dopants de type p, par exemple de bore, dans la partie latérale 31 de la couche semiconductrice de passivation 30 de manière à obtenir une partie latérale 31 dopée p+ sur toute son épaisseur, avec un niveau de dopage par exemple compris entre 10¹⁹ et 10²¹ at/cm3. L'implantation ionique est réalisée de manière localisée au travers d'une ouverture traversante pratiquée dans une résine photosensible 52. On retire ensuite la résine photosensible. Ainsi, la couche semiconductrice de passivation 30 comporte une partie latérale 31 dopée p+ qui affleure la face supérieure de la couche semiconductrice de passivation 30, et une partie supérieure 32 intrinsèque.

Lors d'une étape suivante (2H), on effectue avantageusement un recuit assurant la diffusion des éléments dopants de type p (bore) depuis la partie latérale 31 dopée p+ vers la portion semiconductrice de détection 20 via la bordure latérale 20C. On obtient ainsi une région latérale 25 dopée p+ s'étendant dans la portion semiconductrice de détection 20 suivant l'axe Z au niveau de la bordure latérale 20c. Le recuit de diffusion des dopants p peut être effectué à une température par exemple comprise entre 700°C et 850°C, pendant une durée par exemple comprise entre 10min et 5h. En variante, le recuit d'interdiffusion et le recuit de diffusion peuvent être un même recuit effectué après dopage de type p de la partie latérale 31 de la couche semiconductrice de passivation 30.

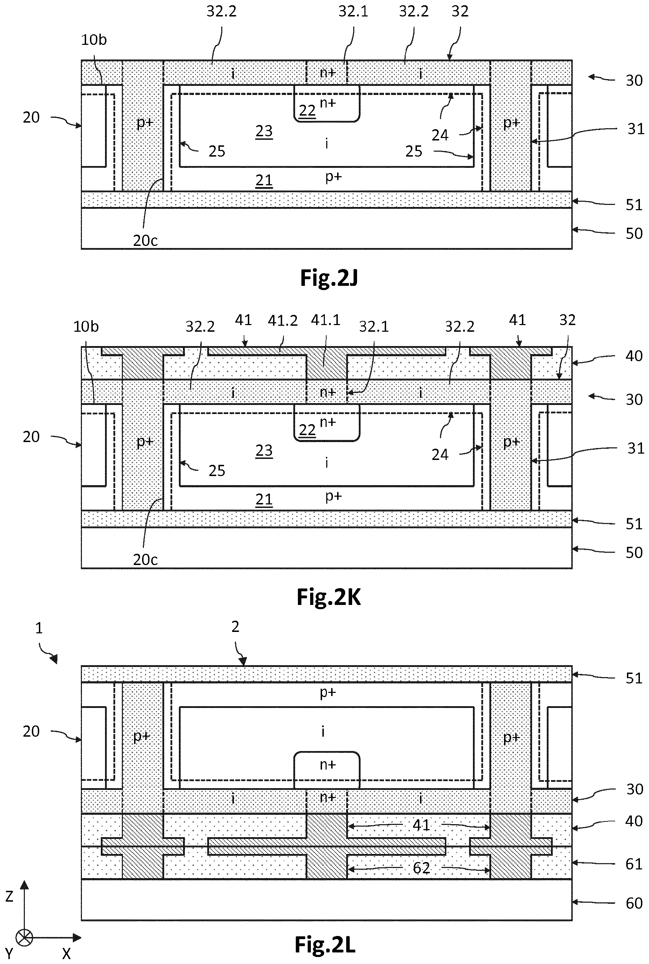

Lors d'une étape suivante (fig.2I et 2J), on réalise ensuite la deuxième région 22 dopée n+ de la portion semiconductrice de détection 20, ici en deux temps. Tout d'abord (fig.2I), on définit une zone d'implantation ionique de dopants de type n, par exemple du phosphore, arsenic ou antimoine, au moyen d'une ouverture traversante d'une résine photosensible 53 (fig.2I). L'ouverture traversante est située en regard d'une zone centrale de la photodiode 2, et présente des dimensions dans le plan XY correspondant aux dimensions souhaitées de la deuxième région 22 dopée n+. Elles peuvent être comprises, par exemple entre 300nm et 90µm. On effectue une implantation ionique d'un dopant tel que le phosphore, au travers de l'ouverture de la résine photosensible 53, dans une portion centrale 32.1 initialement intrinsèque de la couche semiconductrice de passivation 30, pour la rendre dopée n+. On peut ensuite supprimer la résine photosensible 53. Ensuite (fig.2J), on effectue au moins un recuit assurant la diffusion des éléments dopants n depuis la portion centrale 32.1 dopée n+ de la couche semiconductrice de passivation 30 vers la portion semiconductrice de détection 20, par exemple à une première température de 800°C pendant 5min puis à une deuxième température comprise entre 600°C et 700°C pendant 5s à 60s. On obtient ainsi la deuxième région 22 dopée n+. Par cette étape de réalisation en deux temps de la deuxième région 22 dopée n+, on limite ainsi les défauts liés à une implantation ionique d'éléments dopants de type n directement dans la portion semiconductrice de détection 20.

La deuxième région 22 dopée n+ forme ainsi un caisson dopé délimité dans le plan XY et suivant la direction par la région intermédiaire 23 de germanium intrinsèque. Elle est de préférence surdopée n+, et peut ainsi présenter un niveau de dopage de l'ordre de 10¹⁹ at/cm3. A titre d'exemple, on peut avoir un dopage dans la portion centrale 32.1 de l'ordre de 10²¹ at/cm³ à l'interface avec la couche 40, et de l'ordre de 10¹⁹ at/cm³ à l'interface avec la région 22, puis le dopage dans la région 22 diminue de 10¹⁹ at/cm³ à une valeur de l'ordre de 10¹⁴ at/cm³ dans la région intrinsèque 23. Par le fait que le recuit d'interdiffusion du silicium et du germanium ainsi que le recuit de diffusion des éléments dopants de type p sont effectués avant la réalisation de la deuxième région 22 dopée n+, celle-ci présente des dimensions contrôlées. En effet, les éléments dopants de type n dans le germanium (phosphore, arsenic...) présentent un coefficient de diffusion important, plus importante que celle des éléments dopants de type p (bore, gallium...). Aussi, les dimensions de la région latérale 25 dopée p+ ne sont sensiblement pas ou peu modifiées, et les dimensions de la deuxième région 22 dopée n+ correspondent à celles souhaitées.

Ainsi, on obtient une deuxième région 22 dopée n+ au sein de la portion semiconductrice de détection 20, entourée par la région intermédiaire 23 en germanium intrinsèque dans le plan XY. La couche semiconductrice de passivation 30 comporte une partie latérale 31 dopée p+ qui est au contact de la première région 21 dopée p+ et de la région latérale 25 dopée p+ ; une partie supérieure 32 formée d'une portion centrale 32.1 dopée n+ au contact de la deuxième région 22 dopée n+ ; et une portion périphérique 32.2 intrinsèque qui entoure la portion centrale 32.1 dopée n+ et sépare physiquement et électriquement celle-ci de la partie latérale 31 dopée p+. La portion centrale 32.1 dopée n+ et la partie latérale 31 dopée p+ affleurent la face supérieure de la couche semiconductrice de passivation 30.

Lors d'une étape suivante (fig.2K), on réalise ensuite une couche d'interconnexion électrique. Pour cela, on dépose une couche isolante supérieure 40 de manière à recouvrir continûment la couche semiconductrice de passivation 30. Elle peut être réalisée en un matériau diélectrique, par exemple un oxyde, nitrure ou oxynitrure de silicium, un oxyde ou nitrure d'aluminium, un oxyde d'hafnium, entre autres. La couche isolante supérieure 40 peut présenter une épaisseur par exemple comprise entre 10nm et 500nm. Un recuit sous N₂H₂ (par ex. 90% N₂ et 10% H₂) peut être effectuée à une température de l'ordre de 400°C à 450°C pour passiver les liaisons pendantes à l'interface Si/Ge.

Enfin, on réalise des métallisations de contact 41, s'étendant au travers de la couche isolante supérieure 40, et venant au contact de la portion centrale 32.1 dopée n+ d'une part, et de la partie latérale 31 dopée p+ d'autre part. La portion périphérique 32.2 intrinsèque de la couche semiconductrice de passivation 30 n'est pas au contact d'une métallisation de contact. Les métallisations de contact 41 peuvent être réalisées de manière classique, par remplissage des ouvertures traversant la couche isolante supérieure 40 d'au moins un matériau métallique (couche barrière à base de Ti, cœur en cuivre), suivi d'une étape de planarisation CMP. Chaque métallisation de contact 41 peut présenter une partie inférieure 41.1 au contact de la couche semiconductrice de passivation 30, et une partie supérieure 41.2 affleurant la face supérieure de la couche isolante supérieure 40. La partie supérieure 41.2 présente avantageusement de dimensions transversales, dans le plan XY, supérieures à celles de la partie inférieure 41.1, et assure ainsi une fonction supplémentaire de réflexion du rayonnement lumineux reçu au travers de la première face 10a, celle-ci formant la face de réception du rayonnement lumineux à détecter.

Lors d'une étape suivante (fig.2L), on assure l'hybridation de l'empilement optoélectronique ainsi obtenu sur une puce de commande 60. La face de connexion de la puce de commande 60 peut ainsi être revêtue d'une couche isolante 61, réalisée en un matériau diélectrique, traversée par des métallisations de contact 62. L'empilement optoélectronique et la puce de commande 60 sont ainsi assemblés par adhésion moléculaire hybride, par contact des faces formées des métallisations de contact 41, 62 et des couches isolantes 40, 61. Un recuit de collage peut être effectué de manière à augmenter l'énergie de collage surfacique entre les deux faces en contact.

On réalise ensuite la suppression de la couche support 50, par exemple par abrasion (*grinding,* en anglais), de manière à exposer la couche isolante inférieure 51. Celle-ci forme ainsi la face de réception du rayonnement lumineux à détecter, et assure avantageusement une fonction d'antireflet.

Le procédé de fabrication permet ainsi d'obtenir une matrice de photodiodes 2 planaires réalisées à base de germanium, dont la bordure latérale 20C et la deuxième face 10b sont passivées par une couche semiconductrice de passivation 30 réalisée à base de silicium. La zone périphérique 24 à base de silicium germanium ainsi formée permet de limiter les composantes surfaciques du courant d'obscurité.

De plus, dans la mesure où la deuxième région 22 dopée n+ est formée par diffusion de dopants à partir d'une portion centrale 32.1 dopée n+ de la couche semiconductrice de passivation 30, et cela après le recuit d'interdiffusion du silicium et du germanium, et après l'éventuel recuit de diffusion des dopants de type p depuis la partie latérale 31 dopée p+, le procédé de fabrication permet de préserver les dimensions de la deuxième région 22 dopée n+. Ainsi, tout risque de court-circuit des photodiodes 2 par une modification excessive des dimensions des deuxièmes régions 22 dopées est ainsi écarté.

Par ailleurs, les performances des photodiodes 2 sont également améliorées notamment par les caractéristiques suivantes : les régions latérales 25 dopées p situées au niveau de la bordure latérale 20C, les parties supérieures larges 41.2 des métallisations de contact 41, les deuxièmes régions 22 dopées obtenues par diffusion de dopants et non pas par implantation ionique directement dans la portion semiconductrice de détection 20.

Des modes de réalisation particuliers viennent d'être décrits. Différentes variantes et modifications apparaîtront à l'homme du métier. Ainsi, comme mentionné précédemment, la partie latérale 31 de la couche semiconductrice de passivation 30 peut ne pas être dopée de type p. La première région 21 dopée p peut alors être polarisées à partir d'un contact électrique situé au niveau de la première face 10a.

## Revendications

1. Procédé de fabrication d'un dispositif optoélectronique (1) comportant une matrice de photodiodes (2) planaires réalisées à base de germanium, comportant les étapes suivantes :
i) réalisation d'un empilement de couches semiconductrices (11, 12), réalisées à base de germanium, présentant une première face (10a) et une deuxième face (10b) opposées l'une à l'autre et parallèles à un plan principal des photodiodes (2), et comportant :
∘ une première couche (11), dopée de type p, et définissant la première face (10a),
∘ une deuxième couche (12), recouvrant la première couche (11), et définissant la deuxième face (10b),
ii) réalisation de tranchées (13), s'étendant au travers dudit empilement à partir de la deuxième face (10b) en direction de la première face (10a),délimitant pour chaque photodiode (2) une portion semiconductrice (20) dudit empilement ;
iii) dépôt d'une couche semiconductrice intrinsèque de passivation (30), réalisée à base de silicium, recouvrant la deuxième face (10b) et remplissant les tranchées (13) ;
iv) recuit, assurant, pour chaque photodiode (2), une interdiffusion du silicium de la couche semiconductrice de passivation (30) et du germanium de la portion semiconductrice (20), formant ainsi une zone dite périphérique (24) de la portion semiconductrice (20), réalisée à base de silicium germanium, et située au contact de la couche semiconductrice de passivation (30).

2. Procédé selon la revendication 1, comportant, à la suite de l'étape de recuit d'interdiffusion, une étape de réalisation, pour chaque photodiode (2), d'une région dite supérieure (22) dopée n de la portion semiconductrice (20), affleurant la deuxième face (10b) et située à distance d'une bordure latérale (20c) de la portion semiconductrice (20) reliant les première et deuxième faces (10a, 10b) l'une à l'autre, par les sous-étapes suivantes :
∘ implantation ionique localisée d'éléments dopants de type n dans une portion dite centrale (32.1) de la couche semiconductrice de passivation (30),
∘ recuit, assurant une diffusion des éléments dopants de type n depuis la portion centrale (32.1) vers la portion semiconductrice (20), formant ainsi la région supérieure (22) dopée n.

3. Procédé selon la revendication 1 ou 2, comportant une étape de dopage de parties dites latérales (31) de la couche semiconductrice de passivation (30), situées dans les tranchées (13), par implantation ionique localisée d'éléments dopants de type p, formant ainsi pour chaque photodiode (2) une partie latérale (31) dopée p, suivie d'une étape de recuit assurant la diffusion des éléments dopants de type p depuis les parties latérales (31) vers les portions semiconductrices (20), formant ainsi, dans chaque portion semiconductrice (20), une région dite latérale (25) dopée p affleurant une bordure latérale (20c) de la portion semiconductrice (20).

4. Procédé selon les revendications 2 et 3, dans lequel l'étape de recuit de diffusion des éléments dopants du type p est effectuée avant ou lors de l'étape de recuit de diffusion des éléments dopants du type n.

5. Procédé selon l'une quelconque des revendications 1 à 4, comportant une étape de réalisation d'une couche d'interconnexion électrique, comportant :
- un dépôt d'une couche isolante supérieure (40) réalisée en un matériau diélectrique, recouvrant la couche semiconductrice de passivation (30), puis
- une formation, au travers de la couche isolante supérieure (40), de portions conductrices (41), venant au contact, pour chaque photodiode (2), d'une partie dite latérale (31) dopée p de la couche semiconductrice de passivation (30) située dans une tranchée (13) d'une part, et d'une portion dite centrale (32.1) dopée n de la couche semiconductrice de passivation (30) située sur la deuxième face (10b) et au contact d'une région dite supérieure (22) dopée n de la portion semiconductrice (20).

6. Dispositif optoélectronique (1) comportant une matrice de photodiodes (2) planaires réalisées à base de germanium, présentant une première face (20a) et une deuxième face (20b) opposées l'une à l'autre et parallèles à un plan principal des photodiodes (2), chaque photodiode (2) comportant :
∘ une portion semiconductrice (20), comportant :
• une première région (21) dite inférieure dopée de type p et affleurant la première face (10a),
• une deuxième région (22) dite supérieure dopée de type n et affleurant la deuxième face (10b),
• une région intermédiaire (23) située entre les première et deuxième régions (21, 22) et entourant la deuxième région (22) dans le plan principal,
∘ une tranchée (13), s'étendant à partir de la deuxième face (10b) en direction de la première face (10a),et définissant une bordure latérale (20C) de la portion semiconductrice (20) reliant les première et deuxième faces (10a, 10b) ;
∘ une couche semiconductrice de passivation (30), réalisée à base de silicium, recouvrant la deuxième face (10b) et remplissant la tranchée (13) ;
∘ une zone dite périphérique (24) réalisée à base de silicium germanium, située dans la portion semiconductrice (20) au contact de la couche semiconductrice de passivation (30) au niveau de la deuxième face (10b) et au niveau de la bordure latérale (20c).

7. Dispositif optoélectronique (1) selon la revendication 6, dans lequel la couche semiconductrice de passivation (30) comporte une partie dite supérieure (32) s'étendant au contact de la deuxième face (10b),et une partie dite latérale (31) remplissant les tranchées (13) et s'étendant au contact de la bordure latérale (20C), la partie supérieure (32) comportant une portion dite centrale (32.1) dopée de type n et située au contact de la deuxième région (22) dopée n, et une portion dite périphérique (32.2), entourant la portion centrale (32.1) dans le plan principal.

8. Dispositif optoélectronique (1) selon la revendication 7, dans lequel la partie latérale (31) est dopée de type p, et est au contact de la première région (21) dopée p.

9. Dispositif optoélectronique (1) selon la revendication 8, dans lequel chaque portion semiconductrice (20) comporte une région dite latérale (25) dopée de type p et située au contact de la partie latérale (31) dopée p.

10. Dispositif optoélectronique (1) selon l'une quelconque des revendications 6 à 9, comportant une puce de commande (60) adaptée à polariser les photodiodes (2), assemblée et électriquement connectée à la matrice de photodiodes (2) au niveau de la deuxième face (10b).

## Patentansprüche

1. Verfahren zur Herstellung einer optoelektronischen Vorrichtung (1), die eine Matrix von auf Germaniumbasis hergestellten planaren Fotodioden (2) umfasst, die folgenden Schritte umfassend:
i) Herstellung eines Stapels von auf Germaniumbasis hergestellten Halbleiterschichten (11, 12), der eine erste Seite (10a) und eine zweite Seite (10b) aufweist, die einander gegenüberliegen und parallel zu einer Hauptebene der Fotodioden (2) sind, und umfasst:
∘ eine erste Schicht (11), die p-dotiert ist und die erste Seite (10a) definiert,
∘ eine zweite Schicht (12), welche die erste Schicht (11) bedeckt und die zweite Seite (10b) definiert,
ii) Herstellung von Gräben (13), die sich von der zweiten Seite (10b) aus in Richtung der ersten Seite (10a) durch den Stapel erstrecken, wobei sie für jede Fotodiode (2) einen Halbleiterabschnitt (20) des Stapels begrenzen;
iii) Aufbringung einer auf Siliziumbasis hergestellten Passivierungs-Eigenhalbleiterschicht (30), welche die zweite Seite (10b) bedeckt und die Gräben (13) füllt;
iv) Temperung, welche für jede Fotodiode (2) eine Interdiffusion des Siliziums der Passivierungs-Halbleiterschicht (30) und des Germaniums des Halbleiterabschnitts (20) sicherstellt, wodurch ein sogenannter Peripheriebereich (24) des Halbleiterabschnitts (20) gebildet wird, der auf der Basis von Siliziumgermanium ausgebildet ist und sich in Kontakt mit der Passivierungs-Halbleiterschicht (30) befindet.

2. Verfahren nach Anspruch 1, welches im Anschluss an den Schritt der Temperung zur Interdiffusion einen Schritt der Herstellung, für jede Fotodiode (2), eines n-dotierten, sogenannten oberen Bereichs (22) des Halbleiterabschnitts (20), der mit der zweiten Seite (10b) bündig ist und sich in einem Abstand von einem die erste und die zweite Seite (10a, 10b) miteinander verbindenden seitlichen Rand (20c) des Halbleiterabschnitts (20) befindet, umfasst, durch die folgenden Teilschritte:
∘ lokale lonenimplantation von n-Dotierelementen in einen sogenannten zentralen Abschnitt (32.1) der Passivierungs-Halbleiterschicht (30),
∘ Temperung, welche eine Diffusion der n-Dotierelemente vom zentralen Abschnitt (32.1) aus zum Halbleiterabschnitt (20) hin sicherstellt, wobei somit der n-dotierte obere Bereich (22) gebildet wird.

3. Verfahren nach Anspruch 1 oder 2, welches einen Schritt der Dotierung von sogenannten seitlichen Teilen (31) der Passivierungs-Halbleiterschicht (30), die sich in den Gräben (13) befinden, durch lokale Ionenimplantation von p-Dotierelementen umfasst, wobei somit für jede Fotodiode (2) ein p-dotierter seitlicher Teil (31) gebildet wird, gefolgt von einem Schritt der Temperung, der die Diffusion der p-Dotierelemente von den seitlichen Teilen (31) aus zu den Halbleiterabschnitten (20) hin sicherstellt, wobei somit in jedem Halbleiterabschnitt (20) eine p-dotierte, sogenannte seitliche Region (25) gebildet wird, die mit dem seitlichen Rand (20c) des Halbleiterabschnitts (20) bündig ist.

4. Verfahren nach einem der Ansprüche 2 und 3, wobei der Schritt der Diffusionstemperung der p-Dotierelemente vor oder während des Schrittes der Diffusionstemperung der n-Dotierelemente durchgeführt wird.

5. Verfahren nach einem der Ansprüche 1 bis 4, welches einen Schritt der Herstellung einer elektrischen Verbindungsschicht umfasst, welcher umfasst:
- eine Aufbringung einer aus einem dielektrischen Material hergestellten oberen Isolationsschicht (40), welche die Passivierungs-Halbleiterschicht (30) bedeckt, anschließend
- eine Ausbildung, durch die obere Isolationsschicht (40) hindurch, von leitenden Abschnitten (41), welche, für jede Fotodiode (2), einerseits mit einem p-dotierten sogenannten seitlichen Teil (31) der Passivierungs-Halbleiterschicht (30), der sich in einem Graben (13) befindet, in Kontakt kommen, und mit einem n-dotierten sogenannten zentralen Abschnitt (32.1) der Passivierungs-Halbleiterschicht (30), der sich auf der zweiten Seite (10b) befindet und mit einer n-dotierten sogenannten oberen Region (22) des Halbleiterabschnitts (20) in Kontakt steht.

6. Optoelektronische Vorrichtung (1), welche eine Matrix von auf Germaniumbasis hergestellten planaren Fotodioden (2) umfasst, die eine erste Seite (20a) und eine zweite Seite (20b) aufweisen, die einander gegenüberliegen und parallel zu einer Hauptebene der Fotodioden (2) sind, wobei jede Fotodiode (2) umfasst:
∘ einen Halbleiterabschnitt (20), welcher umfasst:
• eine erste, sogenannte untere Region (21), die p-dotiert ist und mit der ersten Seite (10a) bündig ist,
• eine zweite, sogenannte obere Region (22), die n-dotiert ist und mit der zweiten Seite (10b) bündig ist,
• eine Zwischenregion (23), die sich zwischen der ersten und der zweiten Region (21, 22) befindet und die zweite Region (22) in der Hauptebene umgibt,
∘ einen Graben (13), der sich von der zweiten Seite (10b) aus in Richtung der ersten Seite (10a) erstreckt und einen seitlichen Rand (20c) des Halbleiterabschnitts (20) definiert, der die erste und die zweite Seite (10a, 10b) verbindet;
∘ eine auf Siliziumbasis hergestellte Passivierungs-Halbleiterschicht (30), welche die zweite Seite (10b) bedeckt und den Graben (13) füllt;
∘ einen auf der Basis von Siliziumgermanium ausgebildeten sogenannten Peripheriebereich (24), der sich an der zweiten Seite (10b) und am seitlichen Rand (20c) mit der Passivierungs-Halbleiterschicht (30) in Kontakt befindet.

7. Optoelektronische Vorrichtung (1) nach Anspruch 6, wobei die Passivierungs-Halbleiterschicht (30) einen sogenannten oberen Teil (32), der sich in Kontakt mit der zweiten Seite (10b) erstreckt, und einen sogenannten seitlichen Teil (31), der die Gräben (13) füllt und sich in Kontakt mit dem seitlichen Rand (20c) erstreckt, umfasst, wobei der obere Teil (32) einen sogenannten zentralen Abschnitt (32.1), der n-dotiert ist und sich in Kontakt mit der n-dotierten zweiten Region (22) befindet, und einen sogenannten peripheren Bereich (32.2), der den zentralen Abschnitt (32.1) in der Hauptebene umgibt, umfasst.

8. Optoelektronische Vorrichtung (1) nach Anspruch 7, wobei der seitliche Teil (31) p-dotiert ist und mit der p-dotierten ersten Region (21) in Kontakt steht.

9. Optoelektronische Vorrichtung (1) nach Anspruch 8, wobei jeder Halbleiterabschnitt (20) eine sogenannte seitliche Region (25) umfasst, die p-dotiert ist und sich mit dem p-dotierten seitlichen Teil (31) in Kontakt befindet.

10. Optoelektronische Vorrichtung (1) nach einem der Ansprüche 6 bis 9, welche einen Steuerchip (60) umfasst, der dazu eingerichtet ist, die Fotodioden (2) zu polarisieren, und mit der Matrix von Fotodioden (2) an der zweiten Seite (10b) zusammengebaut und elektrisch verbunden ist.

## Claims

1. Method for manufacturing an optoelectronic device (1) comprising an array of planar photodiodes (2) formed on the basis of germanium, comprising the following steps:
i) producing a stack of semiconductor layers (11, 12), which are formed on the basis of germanium, having a first face (10a) and a second face (10b) opposite one another and parallel to a main plane of the photodiodes (2), and comprising:
∘ a first, p-doped, layer (11) defining the first face (10a),
∘ a second layer (12), covering the first layer (11), defining the second face (10b),
ii) producing trenches (13), extending through said stack from the second face (10b) towards the first face (10a), delimiting, for each photodiode (2), a semiconductor portion (20) of said stack;
iii) depositing an intrinsic semiconductor passivation layer (30), formed on the basis of silicon, covering the second face (10b) and filling the trenches (13);
iv) annealing, ensuring, for each photodiode (2), an interdiffusion of the silicon of the semiconductor passivation layer (30) and of the germanium of the semiconductor portion (20), thus forming a "peripheral" zone (24) of the semiconductor portion (20), formed on the basis of silicon-germanium, and located in contact with the semiconductor passivation layer (30).

2. Method according to Claim 1, comprising, following the interdiffusion annealing step, a step of producing, for each photodiode (2), an n-doped "upper" region (22) of the semiconductor portion (20), flush with the second face (10b) and located at a distance from a lateral border (20c) of the semiconductor portion (20) connecting the first and second faces (10a, 10b) to one another, by means of the following sub-steps:
∘ localized ion-implanting of n-type dopant elements in a "central" portion (32.1) of the passivation semiconductor layer (30),
∘ annealing, ensuring diffusion of the n-type dopant elements from the central portion (32.1) towards the semiconductor portion (20), thus forming the n-doped upper region (22).

3. Method according to Claim 1 or 2, comprising a step of doping "lateral" portions (31) of the passivation semiconductor layer (30), which are located in the trenches (13), by means of localized ion-implanting of p-type dopant elements, thus forming, for each photodiode (2), a p-doped lateral portion (31), followed by an annealing step ensuring the diffusion of the p-type dopant elements from the lateral portions (31) towards the semiconductor portions (20), thus forming, in each semiconductor portion (20), a p-doped "lateral" region (25) flush with a lateral border (20c) of the semiconductor portion (20).

4. Method according to Claims 2 and 3, wherein the step of diffusion-annealing of the p-type dopant elements is performed before or during the step of diffusion-annealing of the n-type dopant elements.

5. Method according to any one of Claims 1 to 4, comprising a step of producing an electrical interconnect layer, comprising:
- depositing an upper insulating layer (40) made of a dielectric material, covering the passivation semiconductor layer (30), then
- forming, through the upper insulating layer (40), conductive portions (41), coming into contact, for each photodiode (2), with a p-doped "lateral" portion (31) of the passivation semiconductor layer (30) that is located in a trench (13) on the one hand, and with an n-doped "central" portion (32.1) of the passivation semiconductor layer (30) that is located on the second face (10b) and in contact with a n-doped "upper" region (22) of the semiconductor portion (20).

6. Optoelectronic device (1) comprising an array of planar photodiodes (2) formed on the basis of germanium, having a first face (20a) and a second face (20b) opposite one another and parallel to a main plane of the photodiodes (2), each photodiode (2) comprising:
∘ a semiconductor portion (20), comprising:
• a first, p-doped, "lower" region (21) flush with the first face (10a),
• a second, n-doped, "upper" region (22) flush with the second face (10b),
• an intermediate region (23) located between the first and second regions (21, 22) and surrounding the second region (22) in the main plane,
∘ a trench (13), extending from the second face (10b) towards the first face (10a), and defining a lateral border (20c) of the semiconductor portion (20) connecting the first and second faces (10a, 10b);
∘ a passivation semiconductor layer (30), formed on the basis of silicon, covering the second face (10b) and filling the trench (13);
∘ a "peripheral" zone (24) formed on the basis of silicon-germanium, located in the semiconductor portion (20) in contact with the passivation semiconductor layer (30) at the second face (10b) and at the lateral border (20c).

7. Optoelectronic device (1) according to Claim 6, wherein the passivation semiconductor layer (30) comprises an "upper" part (32) extending in contact with the second face (10b), and a "lateral" part (31) filling the trenches (13) and extending in contact with the lateral border (20c), the upper part (32) comprising an n-doped "central" portion (32.1) located in contact with the n-doped second region (22), and a "peripheral" portion (32.2), surrounding the central portion (32.1) in the main plane.

8. Optoelectronic device (1) according to Claim 7, wherein the lateral portion (31) is p-doped, and is in contact with the first, p-doped, region (21).

9. Optoelectronic device (1) according to Claim 8, wherein each semiconductor portion (20) comprises a p- doped "lateral" region (25) located in contact with the p-doped lateral portion (31).

10. Optoelectronic device (1) according to any one of Claims 6 to 9, comprising a control chip (60) suitable for biasing the photodiodes (2), joined and electrically connected to the array of photodiodes (2) at the second face (10b).
